# EUROPEAN PATENT SPECIFICATION

(11) **EP 2 355 303 B1**
(45) Date of publication and mention of the grant of the patent: **20.05.2015**
(21) Application number: 11250149.9
(22) Date of filing: 10.02.2011
(51) Int. Cl.: H02J 7/00, G01R 31/36

(54) **Battery pack**
Batteriepack
Bloc-batteries

(30) Priority: 11.02.2010 US 303602 P; 08.02.2011 US 201113023531
(43) Date of publication of application: 10.08.2011
(73) Proprietor: Samsung SDI Co., Ltd., Gyeonggi-do (KR)
(72) Inventor: Yang, Jongwoon, Gyeonggi-do (KR); Segawa, Susumu, Gyeonggi-do (KR); Hwang, Euijeong, Gyeonggi-do (KR); KIM, Beomgyu, Gyeonggi-do (KR); KIM, Jinwan, Gyeonggi-do (KR); YUN, Hanseok, Gyeonggi-do (KR)
(74) Representative: Mounteney, Simon James

(56) References cited:
- JP-A- 2006 220 643
- US-A1- 2005 242 667
- US-A1- 2007 268 000
- US-A1- 2008 164 882
- US-A1- 2008 309 317
- US-B2- 7 592 774

## Description

Embodiments of the present invention relate to a battery pack.

In general, a portable electronic apparatus, such as a portable notebook computer or a portable electrical device, includes a chargeable pack. The battery pack typically includes a plurality of battery cells, a voltage sensing and balancing circuit for sensing voltages of the respective battery cells and for maintaining voltage balance, and a controller controlling charging and discharging operations of the respective battery cells.

In a battery pack mounted in a device such as a handheld electrical device, some of battery cells constituting the battery pack are coupled to a voltage sensing and balancing circuit and measured. However, since a typical voltage sensing and balancing circuit has only a limited number of input ports, it may be the case that not all of the battery cells for a desired device can be coupled to the voltage sensing and balancing circuit. Generally, the battery cells are directly connected to an A/D converter provided within the controller to transfer voltages thereof.

US 2007/0268000 discloses a battery pack management apparatus having a plurality of groups of battery cells, wherein each group of cells is connected to a battery management unit. The apparatus includes a switching arrangement for selectively connecting a flying capacitor across each block of cells to transfer a voltage across each block of cells to a voltage detector circuit, which sends the voltage value to a microcomputer.

Some embodiments of the invention are directed to a battery pack which can compensate for temperature dependence of voltages measured from a battery cell and applying the same to an analog-to-digital converter.

Some embodiments of the present invention provide a battery pack including a first diode coupled in a backward direction from a flying capacitor, which is coupled to an analog-to-digital (A/D) converter to correspond to a second diode packaged therewith as one single set. The first diode is positioned in a battery cell voltage input path to store battery cell voltage values in the flying capacitor, thereby suppressing a difference between voltages measured from battery cells depending on temperature characteristics of the diodes.

Some embodiments of the present invention also provide a battery pack including diodes demonstrating the same temperature characteristics by packaging the diodes as one single set.

Some embodiments of the present invention also provide a battery pack including a diode formed in a backward direction to correspond to another diode packaged therewith as one single set, the diode preventing surge current from a voltage supply in a voltage input path from a flying capacitor to an A/D converter.

In the battery pack according to some embodiments of the present invention, a diode is formed in a backward direction from a flying capacitor to an A/D converter to correspond to a diode packaged therewith as one single set, the diode positioned in a battery cell voltage input path to store battery cell voltage values in the flying capacitor, thereby suppressing a difference between voltages measured from battery cells depending on temperature characteristics of the diodes.

In addition, in the battery pack according to some embodiments of the present invention, a diode is formed in a backward direction to correspond to a diode packaged therewith as one single set, the diode preventing surge current from a voltage supply in a voltage input path from a flying capacitor to an A/D converter, thereby suppressing a difference between voltages measured from battery cells depending on temperature characteristics of the diodes.

According to one aspect of the invention, there is provided a battery pack according to claim 1.

The first battery cell may be part of a first group of battery cells, the battery pack further comprising: a second group of battery cells; a voltage sensing and balancing circuit coupled to each of the cells in the second group of battery cells, the voltage sensing and balancing circuit being arranged to sense voltages of each of the cells in second group and to provide data of voltages detected from each of the cells in the second group of battery cells to the analog-to-digital converter.

Preferred features of the invention are set out in claims 2 to 14.

Embodiments of the invention will now be described by way of example and with reference to the accompanying drawings in which:-
FIG. 1 a block diagram illustrating the structure of a battery pack according to an aspect of the present invention;
FIG. 2 is a circuit diagram illustrating the structure of an analog switch of the battery pack illustrated in FIG. 1; and
FIGS. 3 and 4 are circuit diagrams illustrating the operation of the analog switch of the battery pack illustrated in FIG. 1.

Embodiments of the present invention will be described in detail with reference to the accompanying drawings so that it can be easily practiced or carried out by one skilled in the art. When an element is referred to as being "connected to" or "coupled to" another element, it can be directly connected to the another element or be indirectly connected to the another element with one or more intervening elements interposed therebetween. In addition, like reference numerals refer to like elements.

Hereinafter, a structure of a battery pack according to an embodiment of the present invention will be described.

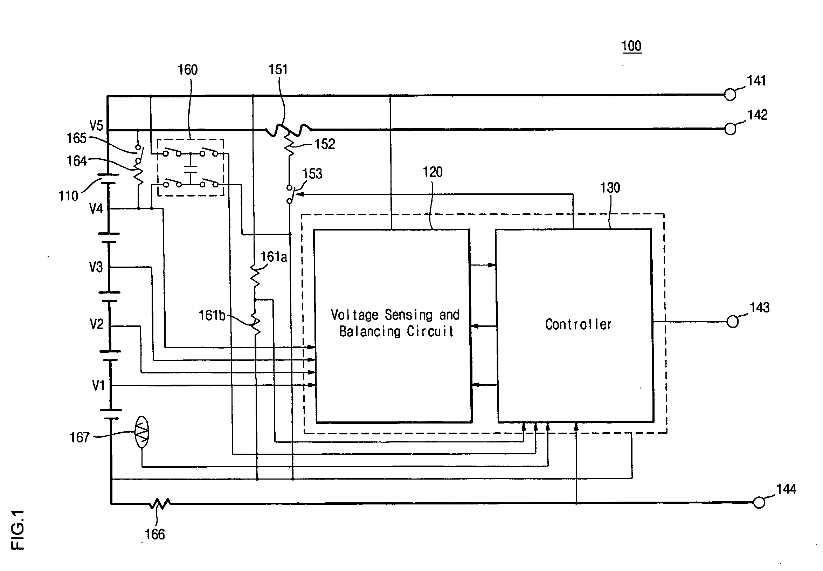

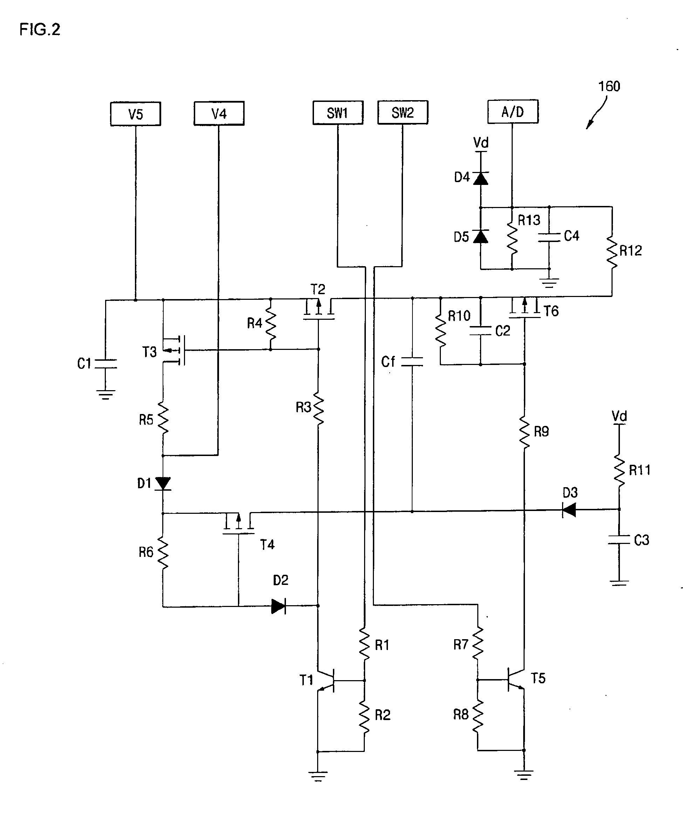

FIG. 1 a block diagram illustrating a structure of a battery pack according to an embodiment of the present invention, and FIG. 2 is a circuit diagram illustrating a structure of an analog switch of the battery pack illustrated in FIG. 1.

Referring to FIG. 1, the battery pack 100 according to the illustrated embodiment of the present invention includes a plurality of rechargeable battery cells 110 connected in series to each other, a voltage sensing and balancing circuit 120 performing voltage sensing and balancing operations of the battery cells 110, and a controller 130.

Here, each of the respective battery cells 110 may be a lithium ion battery that chargeable up to a voltage of approximately 4.2 V, but embodiments of the present invention are not limited thereto. The voltage sensing and balancing circuit 120 may include various kinds of analog front ends manufactured for use as lithium ion batteries, but embodiments of the present invention are not limited thereto. In addition, the controller 130 may include various kinds of microcomputers manufactured for use as lithium ion batteries, but embodiments of the present invention are not limited thereto.

The voltage sensing and balancing circuit 120 supplies power to the controller 130 and provides an analog-to-digital (A/D) converter of the controller 130 with data of voltages detected from four battery cells 110. The controller 130 provides charge/discharge control signals and a balancing control signal corresponding to the data processed by a predetermined program or algorithm (for example, data of voltages detected by the battery cells 110) to the voltage sensing and balancing circuit 120.

The battery pack 100 includes a discharging terminal 141 for discharging the battery cells 110, a charging terminal 142 for charging the battery cells 110, a communication terminal 143 used for single wire communication with an external device, and a negative electrode terminal 144 for charging or discharging the battery cells 110.

Here, the discharging terminal 141 and the charging terminal 142 are electrically connected to positive electrodes of the battery cells 110, the negative electrode terminal 144 is electrically connected to negative electrodes of the battery cells 110, and the communication terminal 143 is electrically connected to the controller 130, respectively.

In addition, the battery pack 100 may further include a fuse 151 connected between the battery cells 110 and the charging terminal 142 to prevent overcharging of the cells. Referring to FIG. 1, the fuse 151 further includes a heat resistor 152 and a switch 153. The switch 153 may be turned on or off by the control signals of the controller 130. In the illustrated embodiment, the fuse 151 is used as the overcharge preventing member, but aspects of the invention are not limited thereto. In other words, the overcharge preventing member according to some embodiments of the invention may include a plurality of field effect transistors.

The battery pack 100 according to the illustrated embodiment of the present invention includes five battery cells 110 connected in series connected to each other. The voltage sensing and balancing circuit 120 is FIG. 1 is designed to detect voltages of only four battery cells 110. In other words, in a conventional arrangement using such a voltage sensing and balancing circuit 120 as shown in FIG.1 the voltage detected from a fifth battery cell 110 cannot be detected without additional changing circuits.

To enable the voltage detection from the fifth battery cell 110, the battery pack 100 according to the illustrated embodiment of the present invention further includes an analog switch 160. The analog switch 160 is connected in parallel between positive and negative electrodes of the fifth battery cell 110. The analog switch 160 stores a voltage of the fifth battery cell 110 and transfers the same to an A/D converter (not shown) of the controller 130.

The battery pack according to this embodiment thus comprises the fifth battery cell having a positive battery terminal and a negative battery terminal and a first group of battery cells (in this embodiment comprising four cells). A controller is provided that is arranged to control charging and discharging operations of the first battery cell. The controller comprises an analog switch arranged to detect a voltage value corresponding to the fifth battery cell and to transfer data of the detected voltage value to the controller, the analog switch including a flying capacitor arranged to store the voltage value corresponding to the fifth battery cell. A voltage sensing and balancing circuit is provided that comprises a number of input terminals equal to the number of cells in the first group of battery cells, each of the input terminals coupled to one of the cells in the first group of battery cells, the voltage sensing and balancing circuit being arranged to sense voltages of each of the cells in first group and to provide data of voltages detected from each of the cells in the first group of battery cells to the controller.

As will be discussed, the analog switch can include a flying capacitor having a first terminal and a second terminal; a first transistor having a first electrode connected to the positive battery terminal, and a second electrode connected to the first terminal of the flying capacitor, the first transistor being controlled according to a first signal from the controller; a first diode comprising an anode connected to the negative battery terminal and a cathode connected to the second terminal of the flying capacitor; a second transistor having a first electrode connected to the first terminal of the flying capacitor, and a second electrode coupled to the analog-to-digital converter, the second transistor being controlled according to a second signal from the controller; and a second diode comprising an anode connected to a first voltage supply, and a cathode connected to the second terminal of the flying capacitor.

Referring to FIG. 2, the analog switch 160 includes a first transistor T1 connected to the controller 130 to perform a switching operation, a second transistor T2, a third transistor T3, and a fourth transistor T4 driven by the first transistor T1. In addition, the analog switch 160 includes a fifth transistor T5 connected to the controller 130 to perform a switching operation, and a sixth transistor T6 driven by the fifth transistor T5.

The first transistor T1 receives a first switching signal SW1 from the controller 130. Here, a first resistor R1 is formed between a control electrode of the first transistor T1 and the controller 130, and a second resistor R2 is formed between the control electrode of the first transistor T1 and a first electrode of the first transistor T1. In addition, the first electrode of the first transistor T1 is connected to ground. Accordingly, the first switching signal SW1 is divided by the first resistor R1 and the second resistor R2 to then be applied to the control electrode of the first transistor T1.

A control electrode of the second transistor T2 is connected to the second electrode of the first transistor T1 through a third resistor R3. Therefore, the second transistor T2 is turned on in response to a signal of the control electrode when the first transistor T1 is turned on. A first electrode of the second transistor T2 is connected to a positive terminal V5 of the fifth battery cell 110. In addition, A second electrode of the second transistor T2 is connected to a flying capacitor Cf, and applies a voltage of the positive terminal V5 to the flying capacitor Cf when the second transistor T2 is turned on.

A control electrode of the third transistor T3 is connected to the second electrode of the first transistor T1 through the third resistor R3. Therefore, the third transistor T3 is also turned on when the first transistor T1 is turned on. A first electrode of the third transistor T3 is connected to the positive terminal V5 of the fifth battery cell 110. Here, the voltage of the positive terminal V5 is stored through the first capacitor C1, to then be applied to the third transistor T3. In addition, a second electrode of the third transistor T3 is connected to the fourth transistor T4 via a fifth resistor R5 and a first diode D1. Here, the first diode D1 prevents a current from flowing backwardly from the flying capacitor Cf through the fourth transistor T4.

A control electrode of the fourth transistor T4 is connected to the second electrode of the first transistor T1 through the second diode D2. In addition, a first electrode of the fourth transistor T4 is connected to the control electrode of the fourth transistor T4 through the sixth resistor R6. Therefore, if a current flows through the sixth resistor R6, the fourth transistor T4 is turned on. In addition, a potential of a node formed between the first diode D1 and the sixth resistor R6 is applied to the flying capacitor Cf through the fourth transistor T4. Meanwhile, a second diode D2 cuts off a surge current applied through the ground.

A first electrode of the flying capacitor Cf is connected between the second electrode of the second transistor T2 and a first electrode of the sixth transistor T6. In addition, a second electrode of the flying capacitor Cf is connected to the second electrode of the fourth transistor T4. As a result, the second electrode of the flying capacitor Cf is coupled to a negative terminal V4 of the fifth battery cell 110 through the first diode D1. Therefore, a voltage corresponding to the sum of the voltage of the fifth battery cell 110 and a driving voltage of the first diode D1 is applied to both terminals of the flying capacitor Cf.

In addition, the second electrode of the flying capacitor Cf is connected to the third capacitor C3 through a third diode D3. The third capacitor C3 stores a voltage of a voltage supply Vd via a resistor R11. An anode of the third diode D3 is connected to the third capacitor C3, and a cathode is connected to the second electrode of the flying capacitor Cf. Accordingly, the voltage Vd stored in the third capacitor C3 and a backward (reverse) driving voltage of the third diode D3 are applied to the second electrode of the flying capacitor. Therefore, the forward driving voltage of the first diode D1 connected to the second electrode of the flying capacitor Cf is offset by the reverse driving voltage of the third diode D3. In this way, a driving voltage difference dependent on the temperature characteristic of the first diode D1 can be eliminated. In addition, in order to make the third diode D3 and the first diode D1 demonstrate the same temperature characteristics, in some embodiments of the first diode D1 and the third diode D3 may be packaged as one single set.

A control electrode of the fifth transistor T5 is connected to the controller 130 through a seventh resistor R7. In addition, an eighth resistor R8 is connected between the control electrode and a first electrode of the fifth transistor T5. Further, the first electrode of the fifth transistor T5 is connected to ground. Accordingly, the second switching signal SW2 is divided by the seventh resistor R7 and a eighth resistor R8 to then be applied to the control electrode of the fifth transistor T5.

A control electrode of the sixth transistor T6 is connected to the second electrode of the fourth transistor T4 through a ninth resistor R9. In addition, the control electrode of the sixth transistor T6 is connected to a first electrode of the sixth transistor T6 through a tenth resistor R10 and a second capacitor C2 connected in parallel to each other. The tenth resistor R10 and the second capacitor C2 increase a gate-source voltage of the sixth transistor T6 with a transient time, thereby preventing the sixth transistor T6 from being turned on at the same time with the second transistor T2 and the fourth transistor T4. A second electrode of the sixth transistor T6 is connected to parallel branches of a thirteenth resistor R13 and a fourth capacitor C4 through a twelfth resistor R12. The fourth capacitor C4 is connected between the twelfth resistor R12 and ground to store the voltage applied from the sixth transistor T6, and applies the same to an A/D converter (A/D) of the controller 130. The thirteenth resistor R13 and the fourth capacitor C4 allow the voltage applied from the sixth transistor T6 to be applied to the A/D converter (A/D) with a transient time.

A fourth diode D4 having an anode connected to the thirteenth resistor R13 and a cathode connected to a voltage supply Vd cuts off a surge current applied from the voltage supply Vd. A fifth diode D5 is connected in parallel to both terminals of the thirteenth resistor R13. An anode of the fifth diode D5 is connected to ground, and a cathode thereof is connected to the anode of the fourth diode D4, thereby compensating for a driving voltage of the fourth diode D4 when the surge current is applied. In such a manner, temperature dependence of the driving voltage of the fourth diode D4 can be offset. Further, in order to make the fifth diode D5 and the fourth diode D4 demonstrate the same temperature characteristics, in some embodiments of the invention the fourth diode D4 and the fifth diode D5 may be packaged as one single set.

In addition, voltage dividing resistors 161 a and 161 b are connected between a discharging terminal 141 and a negative electrode terminal 144, and the voltage dividing resistors 161 a and 161b output the overall voltage of the battery pack 100 to the controller 130.

Hereinafter, the operation of the analog switch of the battery pack according to some embodiments of the present invention will be described.

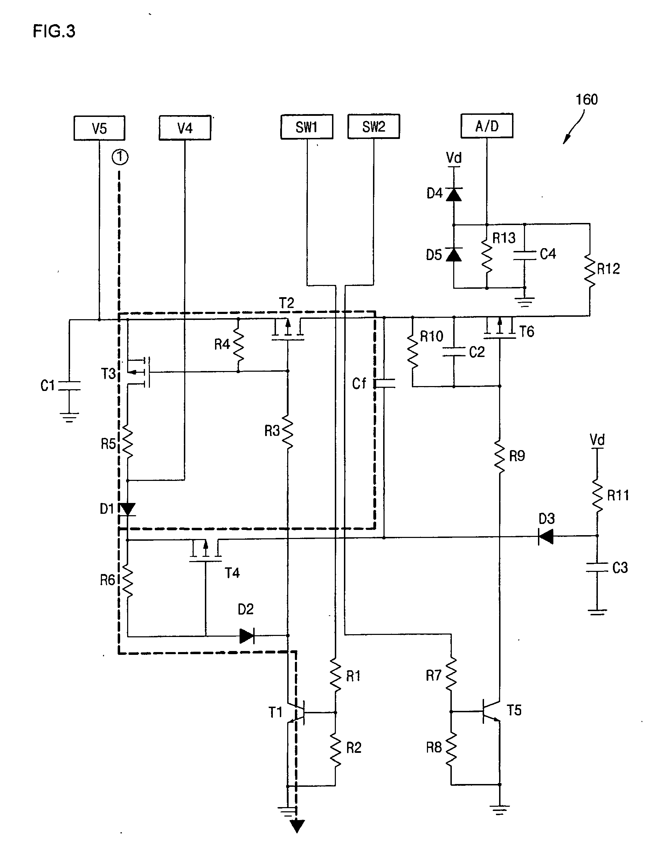

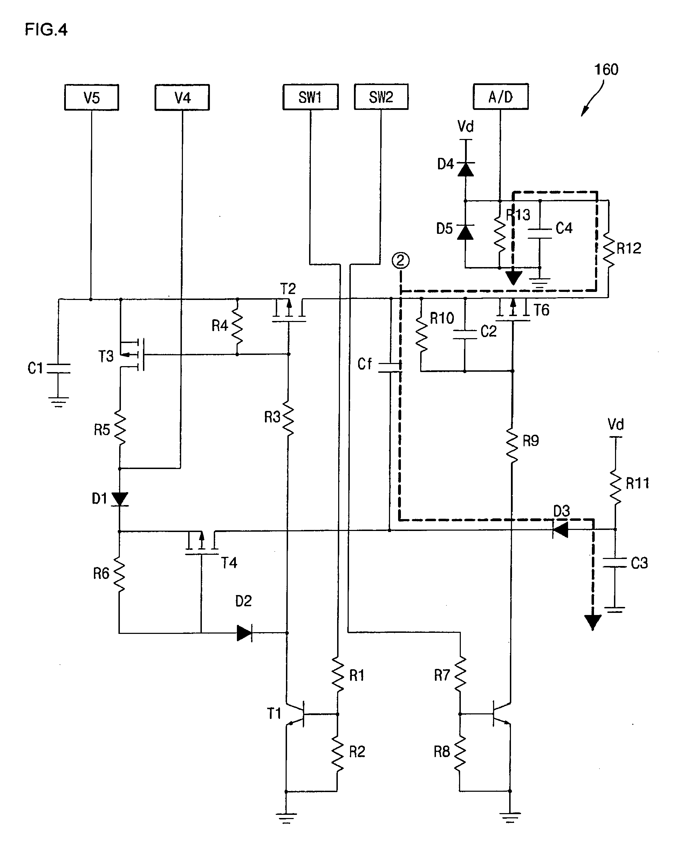

FIGS. 3 and 4 are circuit diagrams illustrating the operation of the analog switch of the battery pack illustrated in FIG. 1.

Referring to FIG. 3, voltage values corresponding to the fifth battery cell 110 are stored in the flying capacitor Cf of the analog switch 160, as indicated by line ①. First, when a first switching signal SW1 is applied, a voltage of the second resistor R2 is applied to the control electrode of the first transistor T1 to turn on the first transistor T1. The current flowing through the first and second electrodes of the first transistor T1 allows a voltage to be applied to control electrodes of the second transistor T2 and the third transistor T3 and turn on the second and third transistors T2 and T3.

As a result, a potential of the positive terminal V5 of the fifth battery cell 110 is transferred to the first electrode of the flying capacitor Cf through the second transistor T2 along the line ①. In addition, a potential of the negative terminal V4 of the fifth battery cell 110 reaches the second electrode of the flying capacitor Cf along the first diode D1 and the fourth transistor T4. Therefore, a voltage corresponding to ((V5-V4)+Vd1) is stored across the flying capacitor Cf. Here, the (V5-V4) is a voltage of either end of the fifth battery cell 110, and Vd1 is a forward driving voltage of the first diode D1.

Referring to FIG. 4, the voltage value corresponding to the fifth battery cell 110 stored in the flying capacitor Cf of the analog switch 160 is transferred to the A/D converter, as indicated by line ②. First, when a second switching signal SW2 is applied, the fifth transistor T5 is turned on. The current flowing through the first and second electrodes of the fifth transistor T5 allows a voltage to be applied to the sixth transistor T6 to turn on the sixth transistor T6. Here, the sixth transistor T6 is turned on with a transition time according to the time constant of the tenth resistor R10 and the second capacitor C2.

As the sixth transistor T6 is turned on, a potential of the first electrode of the flying capacitor Cf is transferred to the twelfth resistor R12 to then become ((V5-V4)+Vd1)+(Vd-Vd3). Here, Vd is a voltage of the voltage supply Vd, which is stored in the third capacitor C3, and Vd3 is a reverse driving voltage of the third diode D3. If the reverse driving voltage of the third diode D3 is equal to the forward driving voltage Vd1 of the first diode D1, the potential of the first electrode of the flying capacitor Cf is ((V5-V4)+Vd). Thus, the term associated with the diode driving voltage is removed. In addition, the potential is divided by the twelfth resistor R12 and the thirteenth resistor R13, and the voltage of the thirteenth resistor R13 is finally transferred to the A/D converter. Here, the thirteenth resistor R13 and the fourth capacitor C4 apply the voltage to the A/D converter with a transient time due to a time constant.

Meanwhile, the fourth diode D4 prevents a surge current from being applied from the voltage supply Vd, and the fifth diode D5 offsets a forward driving voltage of the fourth diode D4. Accordingly, temperature dependence of voltages measured from a battery cell can be compensated for and the voltages can be applied to the A/D converter in a stable manner.

As discussed above, some embodiments of the present invention provide a first battery cell and a first group of battery cells. A controller is provided that is arranged to control charging and discharging operations of the first battery cell. An analog switch arranged to detect a voltage value corresponding to the first battery cell and to transfer data of the detected voltage value to the controller, the analog switch including a flying capacitor arranged to store the voltage value corresponding to the first battery cell. In such embodiments, a voltage sensing and balancing circuit Is provided that comprises a number of input terminals equal to the number of cells in the first group of battery cells, each of the input terminals coupled to one of the cells in the first group of battery cells, the voltage sensing and balancing circuit being arranged to sense voltages of each of the cells in first group and to provide data of voltages detected from each of the cells in the first group of battery cells to the controller. Therefore, in such embodiments, it is possible to use the analog switch including a flying capacitor arranged to store the voltage value corresponding to the first battery cell, allowing more cells to be used than there are inputs on voltage sensing and balancing circuit.

In such embodiments, the first battery cell may be part of a second group of battery cells. In other words, while FIG.1 shows four cells connected to the voltage sensing and balancing circuit (corresponding to the number of inputs) and a single cell connected to the analog switch, other embodiments may include more than just one more cell than the number of inputs of the voltage sensing and balancing circuit.

In other embodiments of the invention, there is provided a battery pack comprising: a battery cell having a positive battery terminal and a negative battery terminal; a controller arranged to control charging and discharging operations of the first battery cell, the controller comprising an analog-to-digital converter; an analog switch arranged to detect a voltage value of the first battery cell and to transfer data of the detected voltage value to the analog-to-digital converter. In such embodiments, the analog switch may include: a flying capacitor having a first terminal and a second terminal; a first transistor having a first electrode connected to the positive battery terminal, and a second electrode connected to the first terminal of the flying capacitor, the first transistor being controlled according to a first signal from the controller; a first diode comprising an anode connected to the negative battery terminal and a cathode connected to the second terminal of the flying capacitor; a second transistor having a first electrode connected to the first terminal of the flying capacitor, and a second electrode coupled to the analog-to-digital converter, the second transistor being controlled according to a second signal from the controller; and a second diode comprising an anode connected to a first voltage supply, and a cathode connected to the second terminal of the flying capacitor.

Although arrangements and actuation mechanisms in the battery pack according to the present invention have been illustrated through particular embodiments, it should be understood that many variations and modifications may be made in those embodiments within the scope of the present invention by selectively combining all or some of the illustrated embodiments herein described.

While the present invention has been described in connection with certain exemplary embodiments, it is to be understood that the invention is not limited to the disclosed embodiments, but, on the contrary, is intended to cover various modifications and equivalent arrangements included within the scope of the appended claims.

## Claims

1. A battery pack comprising:
- a first battery cell (110) and a first group of battery cells;
- a controller (130) arranged to control charging and discharging operations of the first battery cell;
- an analog switch (160) arranged to detect a voltage value corresponding to the first battery cell (110) and to transfer data of the detected voltage value to the controller, the analog switch including a flying capacitor (Cf) arranged to store the voltage value corresponding to the first battery cell, wherein the analog switch comprises:
a first transistor (T2) having a first electrode connected to a first battery terminal (V5) of the first battery cell, and a second electrode connected to a first terminal of the flying capacitor, the first transistor being controlled according to a first signal (SW1) from the controller;
a first diode (D1) comprising an anode connected to a second battery terminal (V4) of the first battery cell and a cathode connected to a second terminal of the flying capacitor;
a second transistor (T6) having a first electrode connected to the first terminal of the flying capacitor, and a second electrode coupled to the controller, the second transistor being controlled according to a second signal (SW2) from the controller; and
a second diode (D3) comprising an anode connected to a first voltage supply, and a cathode connected to the second terminal of the flying capacitor;
- a voltage sensing and balancing circuit (120) comprising a number of input terminals equal to the number of cells in the first group of battery cells, each of the input terminals coupled to one of the cells in the first group of battery cells, the voltage sensing and balancing circuit being arranged to sense voltages of each of the cells in first group and to provide data of voltages detected from each of the cells in the first group of battery cells to the controller.

2. A battery pack according to Claim 1, wherein the first battery cell is part of a second group of battery cells.

3. A battery pack according to Claim 1 or 2, wherein when the first transistor (T2) is turned on, the flying capacitor (Cf) is arranged to store a first voltage, the first voltage corresponding to combination of a voltage of the first battery terminal, a voltage of the second battery terminal and a forward driving voltage of the first diode (D1).

4. A battery pack according to Claim 3, wherein when the second transistor (T6) is turned on, the flying capacitor (Cf) is arranged to provide a second voltage to the second electrode of the second transistor (T6), the second voltage being a sum of the first voltage and a third voltage, wherein the third voltage corresponds to a combination of a voltage of the first voltage supply and a reverse driving voltage of the second diode (D3).

5. A battery pack according to Claim 4, wherein the forward driving voltage of the first diode (D1) is substantially equal in magnitude to the reverse driving voltage of the second diode (D3), wherein optionally the forward driving voltage of the first diode is equal in magnitude to the reverse driving voltage of the second diode.

6. A battery pack according to any one of the preceding Claims, wherein the first diode (D1) has substantially the same characteristics as the second diode (D3), wherein optionally the first diode has same characteristics as the second diode.

7. A battery pack according to any one of the preceding Claims, wherein the first diode (D1) and the second diode (D3) are packaged therewith as one single set.

8. A battery pack according to any one of the preceding Claims, further comprising a third transistor (T3) having a first electrode connected to the first battery terminal (V5), and a second electrode connected to the anode of the first diode (D1), the third transistor being controlled according to the first signal (SW1) from the controller.

9. A battery pack according to any one of the preceding Claims, further comprising a fourth transistor (T4) having a first electrode connected to a control electrode of the fourth transistor, and a second electrode connected to the second terminal of the flying capacitor (Cf), the fourth transistor being controlled according to a first signal from the controller.

10. A battery pack according to Claim 9 when dependent on claim 8, further comprising a fifth transistor (T1), the fifth transistor having a control electrode arranged to receive the first signal (SW1) from the controller via a first resistor (R1), a first electrode connected to ground and to the control electrode of the fifth transistor via a second resistor (R2), and a second electrode connected to the control electrodes of the first, third and fourth transistors (T2, T3, T4).

11. A battery pack according to any one of the preceding Claims, further comprising a sixth transistor (T5), the sixth transistor having a control electrode arranged to receive the second signal (SW2) from the controller via a fourth resistor (R7), a first electrode connected to ground and to the control electrode of the sixth transistor via a fifth resistor (R8), and a second electrode connected to the control electrode of the second transistor (T6).

12. A battery pack according to any one of the preceding Claims, wherein the control electrode of the second transistor (T6) is connected to the first electrode of the second transistor through a sixth resistor (R10) and a second capacitor (C2) connected in parallel to each other.

13. A battery pack according to any one of the preceding Claims, wherein the second electrode of the second transistor (T6) is connected to a seventh resistor (R23) and a third capacitor (C4), the seventh resistor and the third capacitor being connected in parallel to each other, wherein the third capacitor is arranged to store the voltage provided from the second electrode of the second transistor and to supply said voltage to the controller (130).

14. A battery pack according to Claim 13, further comprising a third diode (D4) having an anode connected to the seventh resistor (R13) and a cathode connected to a second voltage supply, and a fourth diode (D5) connected in parallel to both terminals of the seventh resistor.

## Patentansprüche

1. Batteriepack, umfassend:
- eine erste Batteriezelle (110) und eine erste Gruppe von Batteriezellen;
- eine Steuerungseinrichtung (130), die dafür eingerichtet ist, Lade- und Entladeoperationen der ersten Batteriezelle zu steuern;
- einen analogen Schalter (160), der dafür eingerichtet ist, einen Spannungswert zu ermitteln, welcher der ersten Batteriezelle (110) entspricht, und Daten des ermittelten Spannungswerts zur Steuerungseinrichtung zu übertragen, wobei der analoge Schalter einen fliegenden Kondensator (Cf) einschließt, der dafür eingerichtet ist, den Spannungswert zu speichern, welcher der ersten Batteriezelle entspricht, worin der analoge Schalter umfasst:
einen ersten Transistor (T2) mit einer ersten Elektrode, die mit einem ersten Batterieanschluss (V5) der ersten Batteriezelle verbunden ist, und einer zweiten Elektrode, die mit einem ersten Anschluss des fliegenden Kondensators verbunden ist, wobei der erste Transistor gemäß einem ersten Signal (SW1) von der Steuerungseinrichtung gesteuert wird;
eine erste Diode (D1), die eine mit einem zweiten Batterieanschluss (V4) der ersten Batteriezelle verbundene Anode und eine mit einem zweiten Anschluss des fliegenden Kondensators verbundene Kathode umfasst;
einen zweiten Transistor (T6) mit einer ersten Elektrode, die mit dem ersten Anschluss des fliegenden Kondensators verbunden ist, und einer zweiten Elektrode, die mit der Steuerungseinrichtung gekoppelt ist, wobei der zweite Transistor gemäß einem zweiten Signal (SW2) von der Steuerungseinrichtung gesteuert wird; und
eine zweite Diode (D3), die eine mit einer ersten Spannungsversorgung verbundene Anode und eine mit dem zweiten Anschluss des fliegenden Kondensators verbundene Kathode umfasst;
- eine Spannungserfassungs- und -abgleichschaltung (120), die eine Anzahl von Eingangsanschlüssen gleich der Anzahl von Zellen in der ersten Gruppe von Batteriezellen umfasst, wobei jeder der Eingangsanschlüsse mit einer der Zellen in der ersten Gruppe von Batteriezellen gekoppelt ist, wobei die Spannungserfassungs- und -abgleichschaltung dafür eingerichtet ist, Spannungen jeder der Zellen in der ersten Gruppe zu erfassen und Daten über Spannungen, die von jeder der Zellen in der ersten Gruppe von Batteriezellen ermittelt wurden, an die Steuerungseinrichtung zu übergeben.

2. Batteriepack nach Anspruch 1, worin die erste Batteriezelle Teil einer zweiten Gruppe von Batteriezellen ist.

3. Batteriepack nach Anspruch 1 oder 2, worin der fliegende Kondensator (Cf) dafür eingerichtet ist, eine erste Spannung zu speichern, wenn der erste Transistor (T2) eingeschaltet ist, wobei die erste Spannung einer Kombination aus einer Spannung des ersten Batterieanschlusses, einer Spannung des zweiten Batterieanschlusses und einer Vorwärts-Steuerspannung der ersten Diode (D1) entspricht.

4. Batteriepack nach Anspruch 3, worin der fliegende Kondensator (Cf) dafür eingerichtet ist, eine zweite Spannung an die zweite Elektrode des zweiten Transistors (T6) zu übergeben, wenn der zweite Transistor (T6) eingeschaltet ist, wobei die zweite Spannung eine Summe aus der ersten Spannung und einer dritten Spannung ist, worin die dritte Spannung einer Kombination aus einer Spannung der ersten Spannungsversorgung und einer Rückwärts-Steuerspannung der zweiten Diode (D3) entspricht.

5. Batteriepack nach Anspruch 4, worin die Vorwärts-Steuerspannung der ersten Diode (D1) dem Betrag nach im Wesentlichen gleich der Rückwärts-Steuerspannung der zweiten Diode (D3) ist, worin optional die Vorwärts-Steuerspannung der ersten Diode dem Betrag nach gleich der Rückwärts-Steuerspannung der zweiten Diode ist.

6. Batteriepack nach einem der vorhergehenden Ansprüche, worin die erste Diode (D1) im Wesentlichen die gleichen Merkmale wie die zweite Diode (D3) hat, worin optional die erste Diode die gleichen Merkmale wie die zweite Diode hat.

7. Batteriepack nach einem der vorhergehenden Ansprüche, worin die erste Diode (D1) und die zweite Diode (D3) zusammen damit als ein einziger Satz verpackt sind.

8. Batteriepack nach einem der vorhergehenden Ansprüche, ferner umfassend einen dritten Transistor (T3) mit einer ersten Elektrode, die mit dem ersten Batterieanschluss (V5) verbunden ist, und einer zweiten Elektrode, die mit der Anode der ersten Diode (D1) verbunden ist, wobei der dritte Transistor gemäß dem ersten Signal (SW1) von der Steuerungseinrichtung gesteuert wird.

9. Batteriepack nach einem der vorhergehenden Ansprüche, ferner umfassend einen vierten Transistor (T4) mit einer ersten Elektrode, die mit einer Steuerelektrode des vierten Transistors verbunden ist, und einer zweiten Elektrode, die mit dem zweiten Anschluss des fliegenden Kondensators (Cf) verbunden ist, wobei der vierte Transistor gemäß einem ersten Signal von der Steuerungseinrichtung gesteuert wird.

10. Batteriepack nach Anspruch 9, wenn abhängig von Anspruch 8, ferner einen fünften Transistor (T1) umfassend, wobei der fünfte Transistor hat: eine Steuerelektrode, die dafür eingerichtet ist, das erste Signal (SW1) von der Steuerungseinrichtung über einen ersten Widerstand (R1) zu empfangen, eine erste Elektrode, die mit Masse und über einen zweiten Widerstand (R2) mit der Steuerelektrode des fünften Transistors verbunden ist, und eine zweite Elektrode, die mit den Steuerelektroden des ersten, dritten und vierten Transistors (T2, T3, T4) verbunden ist.

11. Batteriepack nach einem der vorhergehenden Ansprüche, ferner einen sechsten Transistor (T5) umfassend, wobei der sechste Transistor hat: eine Steuerelektrode, die dafür eingerichtet ist, das zweite Signal (SW2) von der Steuerungseinrichtung über einen vierten Widerstand (R7) zu empfangen, eine erste Elektrode, die mit Masse und über einen fünften Widerstand (R8) mit der Steuerelektrode des sechsten Transistors verbunden ist, und eine zweite Elektrode, die mit der Steuerelektrode des zweiten Transistors (T6) verbunden ist.

12. Batteriepack nach einem der vorhergehenden Ansprüche, worin die Steuerelektrode des zweiten Transistors (T6) über einen sechsten Widerstand (R10) und einen zweiten Kondensator (C2), die miteinander parallel geschaltet sind, mit der ersten Elektrode des zweiten Transistors verbunden ist.

13. Batteriepack nach einem der vorhergehenden Ansprüche, worin die zweite Elektrode des zweiten Transistors (T6) mit einem siebenten Widerstand (R13) und einem dritten Kondensator (C4) verbunden ist, wobei der siebente Widerstand und der dritte Kondensator miteinander parallel geschaltet sind, worin der dritte Kondensator dafür eingerichtet ist, die von der zweiten Elektrode des zweiten Transistors bereitgestellte Spannung zu speichern und diese Spannung an die Steuerungseinrichtung (130) zu übergeben.

14. Batteriepack nach Anspruch 13, ferner umfassend eine dritte Diode (D4) mit einer Anode, die mit dem siebenten Widerstand (R13) verbunden ist, und einer Kathode, die mit einer zweiten Spannungsversorgung verbunden ist, und eine vierte Diode (D5), die zu beiden Anschlüssen des siebenten Widerstands parallel geschaltet ist.

## Revendications

1. Bloc-batterie comprenant :
- une première cellule de batterie (110) et un premier groupe de cellules de batterie ;
- un dispositif de commande (130) agencé de manière à commander des opérations de chargement et déchargement de la première cellule de batterie ;
- un commutateur analogique (160) agencé pour détecter une valeur de tension correspondant à la première cellule de batterie (110) et pour transférer des données sur la valeur de tension détectée vers le dispositif de commande, le commutateur analogique comprenant un condensateur volant (Cf) agencé pour stocker la valeur de tension correspondant à la première cellule de batterie, dans lequel le commutateur analogique comprend :
un premier transistor (T2) présentant une première électrode raccordée à une première borne de batterie (V5) de la première cellule de batterie, et une deuxième électrode raccordée à une première borne du condensateur volant, le premier transistor étant commandé en fonction d'un premier signal (SW1) en provenance du dispositif de commande ;
une première diode (D1) comprenant une anode raccordée à une deuxième borne de batterie (V4) de la première cellule de batterie et une cathode raccordée à une deuxième borne du condensateur volant ;
un deuxième transistor (T6) présentant une première électrode raccordée à la première borne du condensateur volant, et une deuxième électrode couplée au dispositif de commande, le deuxième transistor étant commandé en fonction d'un deuxième signal (SW2) en provenance du dispositif de commande ; et
une deuxième diode (D3) comprenant une anode raccordée à une première alimentation de tension, et une cathode raccordée à la deuxième borne du condensateur volant ;
- un circuit de détection et d'équilibrage de tension (120) comprenant un certain nombre de bornes d'entrée égal au nombre de cellules du premier groupe de cellules de batterie, chacune des bornes d'entrée étant couplée à une des cellules du premier groupe de cellules de batterie, le circuit de détection et d'équilibrage de tension étant agencé pour détecter des tensions de chacune des cellules du premier groupe et pour fournir au dispositif de commande des données sur des tension détectées à partir de chacune des cellules du premier groupe de cellules de batterie.

2. Bloc-batterie selon la revendication 1, dans lequel la première cellule de batterie fait partie d'un deuxième groupe de cellules de batterie.

3. Bloc-batterie selon la revendication 1 ou 2, dans lequel, lorsque le premier transistor (T2) est activé, le condensateur volant (Cf) est agencé pour stocker une première tension, la première tension correspondant à une combinaison d'une tension de la première borne de batterie, d'une tension de la deuxième borne de batterie et d'une tension d'alimentation directe de la première diode (D1).

4. Bloc-batterie selon la revendication 3, dans lequel, lorsque le deuxième transistor (T6) est activé, le condensateur volant (Cf) est agencé de manière à fournir une deuxième tension à la deuxième électrode du deuxième transistor (T6), la deuxième tension étant une somme de la première tension et d'une troisième tension, la troisième tension correspondant à une combinaison d'une tension de la première alimentation de tension et d'une tension d'alimentation inverse de la deuxième diode (D3).

5. Bloc-batterie selon la revendication 4, dans lequel la tension d'alimentation directe de la première diode (D1) est essentiellement égale en magnitude à la tension d'alimentation inverse de la deuxième diode (D3), la tension d'alimentation directe de la première diode étant éventuellement égale en magnitude à la tension d'alimentation inverse de la deuxième diode.

6. Bloc-batterie selon l'une quelconque des revendications précédentes, dans lequel la première diode (D1) présente essentiellement les mêmes caractéristiques que la deuxième diode (D3), la première diode présentant éventuellement les mêmes caractéristiques que la deuxième diode.

7. Bloc-batterie selon l'une quelconque des revendications précédentes, dans lequel la première diode (D1) et la deuxième diode (D3) sont conditionnées avec celle-ci en tant qu'ensemble unique.

8. Bloc-batterie selon l'une quelconque des revendications précédentes, comprenant en outre un troisième transistor (T3) présentant une première électrode raccordée à la première borne de batterie (V5), et une deuxième électrode raccordée à l'anode de la première diode (D1), le troisième transistor étant commandé en fonction du premier signal (SW1) en provenance du dispositif de commande.

9. Bloc-batterie selon l'une quelconque des revendications précédentes, comprenant en outre un quatrième transistor (T4) présentant une première électrode raccordée à une électrode de commande du quatrième transistor, et une deuxième électrode raccordée à la deuxième borne du condensateur volant (Cf), le quatrième transistor étant commandé en fonction d'un premier signal en provenance du dispositif de commande.

10. Bloc-batterie selon la revendication 9, lorsqu'elle dépend de la revendication 8, comprenant en outre un cinquième transistor (T1), le cinquième transistor présentant une électrode de commande agencée pour recevoir le premier signal (SW1) en provenance du dispositif de commande par l'intermédiaire d'une première résistance (R1), une première électrode raccordée à la terre et à l'électrode de commande du cinquième transistor par l'intermédiaire d'une deuxième résistance (R2), et une deuxième électrode raccordée aux électrodes de commande des premier, troisième et quatrième transistors (T2, T3, T4).

11. Bloc-batterie selon l'une quelconque des revendications précédentes, comprenant en outre un sixième transistor (T5), le sixième transistor présentant une électrode de commande agencée pour recevoir le deuxième signal (SW2) en provenance du dispositif de commande par l'intermédiaire d'une quatrième résistance (R7), une première électrode raccordée à la terre et à l'électrode de commande du sixième transistor par l'intermédiaire d'une cinquième résistance (R8), et une deuxième électrode raccordée à l'électrode de commande du deuxième transistor (T6).

12. Bloc-batterie selon l'une quelconque des revendications précédentes, dans lequel l'électrode de commande du deuxième transistor (T6) est raccordée à la première électrode du deuxième transistor par l'intermédiaire d'une sixième résistance (R10) et d'un deuxième condensateur (C2) raccordés en parallèle l'un à l'autre.

13. Bloc-batterie selon l'une quelconque des revendications précédentes, dans lequel la deuxième électrode du deuxième transistor (T6) est raccordée à une septième résistance (R13) et à un troisième condensateur (C4), la septième résistance et le troisième condensateur étant raccordés en parallèle l'un à l'autre, le troisième condensateur étant agencé pour stocker la tension en provenance de la deuxième électrode du deuxième transistor et pour fournir ladite tension au dispositif de commande (130).

14. Bloc-batterie selon la revendication 13, comprenant en outre une troisième diode (D4) présentant une anode raccordée à la septième résistance (R13) et une cathode raccordée à une deuxième alimentation de tension, et une quatrième diode (D5) raccordée en parallèle aux deux bornes de la septième résistance.
